# EUROPEAN PATENT APPLICATION

(11) **EP 4 618 714 A1**
(43) Date of publication of application: **17.09.2025**
(21) Application number: 25152522.6
(22) Date of filing: 17.01.2025
(51) Int. Cl.: H10D 12/01, H10D 12/00, H10D 62/00, H10D 62/10, H10D 84/00

(54) **SUPER JUNCTION IGBT DEVICE BASED ON CONTROLLED HOLE EXTRACTION STRUCTURE AND MANUFACTURING METHOD THEREOF**

(30) Priority: 11.03.2024 CN 202410275669
(71) Applicant: Chongqing Alpha and Omega Semiconductor Limited, Chongqing 400700 (CN)
(72) Inventor: LIU, Haowen, Chongqing, 400700 (CN)
(74) Representative: Metida

(57) **Abstract**

A super junction IGBT device based on a controlled hole extraction structure and a manufacturing method thereof are provided. The super junction IGBT device includes an epitaxial layer (200). P-type columns and N-type columns (240) are periodically disposed in the epitaxial layer (200). P-type base regions are disposed above the N-type columns (240). The P-type base regions include first P-type base regions (261) disposed in a rectangular array. The P-type columns include first P-type columns (251) and second P-type columns (252). The first P-type columns (251) are connected to the first P-type base regions (261) by the controlled hole extraction structure. When the super junction IGBT device is turned off, the controlled hole extraction structure form a hole extraction channel between the first P-type columns (251) and the first P-type base regions (261), thereby accelerating a turn-off speed by extracting holes.

## Description

### TECHNICAL FIELD

The present disclosure relates to a technical field of integrated circuits, and in particular relates to a super junction IGBT device based on a controlled hole extraction structure and a manufacturing method thereof.

### BACKGROUND

Compared with conventional silicon-based insulated gate bipolar transistor (IGBT) devices, super junction IGBT (SJ-IGBT) devices introduce N-type columns 240 and P-type columns 250 that are periodically and alternately disposed in a drift region thereof, and the SJ-IGBT devices use lateral depletion of the N-type columns 240 and the P-type columns 250 to improve an electric field distribution, thereby having higher withstand voltage and higher current density under the same drift region length. A turn-off speed of SJ-IGBT devices mainly depends on a minority carrier extraction speed during turn-off.

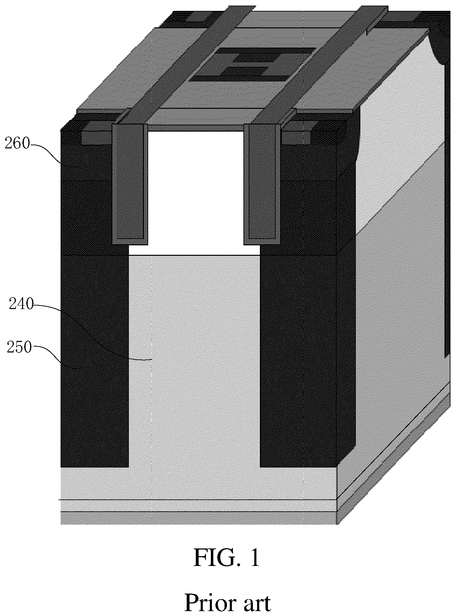

As shown in FIG. 1, in a SJ-IGBT device of the prior art, the P-type columns are commonly located directly below P-type base regions 260 and respectively connected to the P-type base regions 260. The SJ-IGBT device uses lateral depletion of the N-type columns and the P-type columns 250 to improve an electric field distribution thereof, which provides a higher withstand voltage and a higher current density under the same length of a drift region thereof (essentially, a super junction N-type epitaxial layer (SJ-NEPI) region having a higher doping concentration produces a carrier storage (CS) layer effect). Due to an extraction of holes by the P-type columns, a turn-off speed of the SJ-IGBT device is faster. However, since the P-type columns provide a hole extraction channel directly connected to the P-type base regions, a conductivity modulation level of the SJ-IGBT device under forward conduction is affected, causing the SJ-IGBT device to exhibit a larger Vcesat (saturation voltage drop).

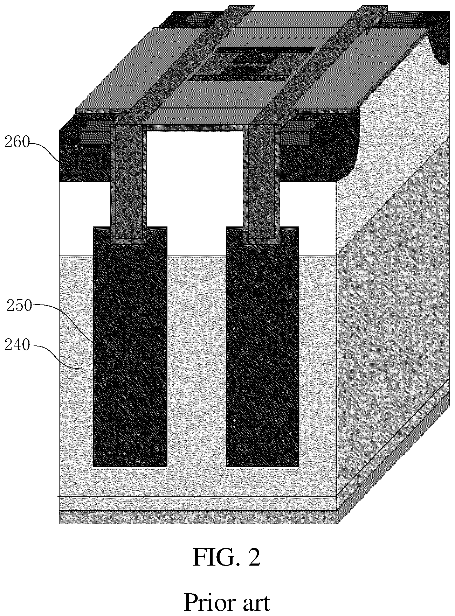

As shown in FIG. 2, in another SJ-IGBT device of the prior art, P-type columns thereof are suspended and are not connected to P-type base regions thereof. In this case, the P-type columns are not respectively disposed directly below the P-type base regions. Of course, the P-type columns may respectively disposed directly below the P-type base regions but not connected to the P-type base regions. In the SJ-IGBT device, since the P-type columns no longer extract holes, the number of carriers injected into a drift region increases and Vcesat decreases. However, since the holes are only extracted from the P-type base regions, extraction efficiency is reduced. Further, since an epitaxial layer of the SJ-IGBT device has a higher N doping concentration, the epitaxial layer further blocks hole extraction, resulting in a longer turn-off time of the SJ-IGBT device and increased switching losses.

### SUMMARY

In view of deficiencies in the prior art, a technical problem to be solved by the present disclosure is to provide a super junction insulated gate bipolar transistor (IGBT) device based on a controlled hole extraction structure and a manufacturing method thereof.

In solve the deficiencies in the prior art, the present disclosure provides the super junction IGBT device. The super junction IGBT device comprises an epitaxial layer. P-type columns and N-type columns are periodically disposed in the epitaxial layer. P-type base regions are disposed above the N-type columns. The P-type base regions comprise first P-type base regions disposed in a rectangular array, and the P-type columns comprise first P-type columns and second P-type columns. The first P-type columns are disposed between two adjacent first P-type base regions 261 in the same column. The second P-type columns are disposed between two adjacent first P-type base regions in the same row. The first P-type columns are connected to the first P-type base regions by the controlled hole extraction structure. The controlled hole extraction structure is configured to define a hole extraction channel between the first P-type columns and the first P-type base regions. When the super junction IGBT device is turned on, the hole extraction channel between the first P-type columns and the first P-type base regions is disconnected.

The present disclosure further provides the manufacturing method of the super junction IGBT device based on the controlled hole extraction structure. The manufacturing method comprises steps:
providing a silicon substrate;
epitaxially growing N-type doped silicon on the silicon substrate to form the epitaxial layer, and forming the first P-type columns and the second P-type columns through injection on the epitaxial layer;
etching the trenches on two sides of the second P-type columns;
forming a gate oxide layer on groove walls of the trenches and an upper surface of the epitaxial layer;
performing an injection process on an upper portion of the epitaxial layer to form the P-type base regions, performing the injection process on upper portions of the P-type base regions to form the emitting regions and the shallow P well;
etching to remove portions of the gate oxide layer on the P-type base region, and depositing polysilicon in the trenches and on the shallow P well to form gate electrodes;
growing the dielectric layer; and
manufacturing contact holes and depositing emitter metal, gate metal, and collector metal.

In the present disclosure the P-type base regions are disposed above the N-type columns so that the P-type columns are not directly connected to the P-type base regions. Then, the shallow P well is defined to form the hole extraction channel connecting the first P-type columns and the first P-type base regions, and the first gate electrode is disposed above the shallow P well to control on and off of the hole extraction channel. When the super junction IGBT device is turned on, the shallow P well is depleted by a gate voltage of the first gate electrode, an extraction of holes by the first P-type columns is blocked, and the holes are inhibited from flowing to top ends of the first P-type columns, which increase a carrier injection concentration of the N- drift region, increase a current density, and reduce conduction loss. When the super junction IGBT device is turned off, the shallow P well is restored, so that the hole extraction channel is opened, and the extraction of the holes by the first P-type columns accelerates a turn-off speed of the super junction IGBT device. Therefore, the turn-off speed of the super junction IGBT device is accelerated, and a saturation voltage drop of the super junction IGBT device is not increased when the super junction IGBT device is turned on.

### BRIEF DESCRIPTION OF DRAWINGS

The drawings described herein are for providing further understanding of the present disclosure and constitute a part of the present disclosure. The illustrative embodiments of the present disclosure and their descriptions are used to explain the present disclosure and do not constitute improper limitations on the present disclosure.
FIG. 1 is a schematic diagram of a cell structure of a SJ-IGBT device in the prior art.
FIG. 2 is a schematic diagram of a cell structure of another SJ-IGBT device in the prior art.
FIG. 3 is a schematic diagram of a cell structure of a super junction IGBT device based on a controlled hole extraction structure according to one optional embodiment of the present disclosure.
FIG. 4 is a front side schematic diagram of the cell structure shown in FIG. 3.
FIG. 5 is a left side schematic diagram of the cell structure shown in FIG. 3.
FIG. 6 is a flow chart of a manufacturing method of the super junction IGBT device based on the controlled hole extraction structure according to one optional embodiment of the present disclosure.
FIG. 7 is a front side schematic diagram of an epitaxial layer after forming first P-type columns and second P-type columns by injection.
FIG. 8 is a top plan schematic diagram of the epitaxial layer after forming the first P-type columns and the second P-type columns by injection.
FIG. 9 is a front side schematic diagram of the epitaxial layer after forming trenches.
FIG. 10 is a top plan schematic diagram of the epitaxial layer after forming the trenches.
FIG. 11 is a front side schematic diagram of the epitaxial layer after forming a gate oxide layer and forming P-type base regions, emitting regions, and a shallow P well by injection
FIG. 12 is a left side schematic diagram of the epitaxial layer after forming the gate oxide layer and forming the P-type base regions, the emitting regions and the shallow P well by injection
FIG. 13 is a top schematic diagram of the epitaxial layer after polysilicon deposition.

### Reference numbers in the drawings:

P + collector region-100; epitaxial layer-200; N-type buffer 210; N- drift region-220; N + blocking region; 230; N-type column-240; P-type column-250; first P-type column-251; second P-type column-252; P-type base region-260; first P-type base region-261; second P-type base region-262; first emitting region-271; N + emitting region-271a; P + contact region-271b; second emitting region-272; shallow P well-280; trench-300; gate oxide layerr-400; first gate oxide layer-410; second gate oxide layer-420; gate electrode-500; first gate electrode-510; second gate electrode-520; dielectric layer-600.

### DETAILED DESCRIPTION

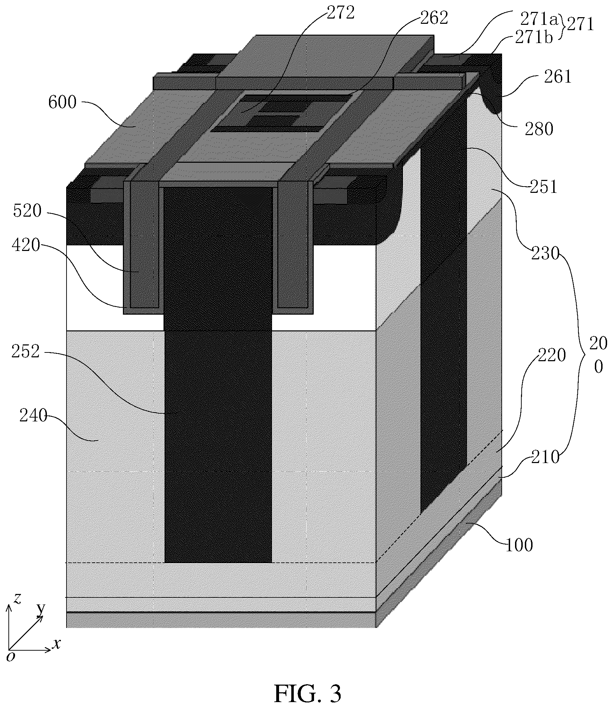

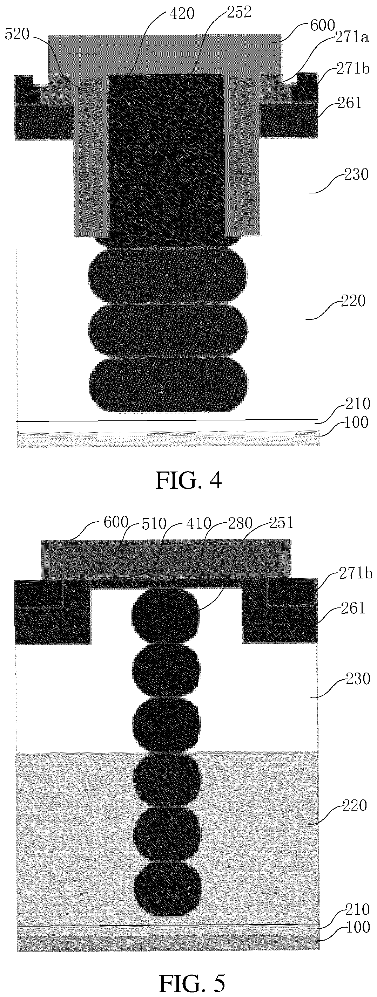

As shown in FIGS. 3-5, the present disclosure provides a super junction insulated gate bipolar transistor (IGBT) device based on a controlled hole extraction structure. In one optional embodiment, the super junction IGBT device comprises an epitaxial layer 200, The epitaxial layer 200 comprises an N-type buffer region 210, an N- drift region 220 disposed on the N-drift region 210, and an N+ barrier region 230 disposed on the N-drift region 220.

P-type columns and N-type columns 240 are periodically disposed in the epitaxial layer 200. The P-type columns are disposed in the N+ barrier region 230, and the P-type columns extend downward into the N- drift region 220. The N- drift region 220 and the N+ barrier region 230 surround the P-type columns to form the N-type columns 240. That is, the N- drift region 220 and the N+ barrier region 230 on left and right sides (two sides along an X-axis direction in FIG. 3) and front and rear sides (two sides along a Y-axis direction in FIG. 3) of the P-type columns form the N-type columns 240, thereby forming the P-type columns and the N-type columns 240 that are periodically and alternately disposed. According to the above structure, it is noted that a doping concentration of upper portions of the N-type columns 240 are inconsistent with a doping concentration of lower portions of the N-type columns 240, the upper portions of the N-type columns 240 are N+ regions and the lower portions of the N-type columns 240 are the N- regions. Similarly, a doping concentration of upper portions of the P-type columns is inconsistent with a doping concentration of lower portions of the P-type columns. Of course, the doping concentration of the upper portions of the P-type columns may be consistent with the doping concentration of the lower portions of the P-type columns. In FIG. 3, lower ends of the N-type columns 240 are indicated by a dashed line because the lower portions of the N-type columns 240 are originally integrated with the N- drift region 220, and there is no real dividing line thereof. The dashed line is configured to distinguish the N-type columns 240 from the N- drift region 220 only to facilitate understanding of positions of the N-type columns 240.

P-type base regions are disposed above the N-type columns 240.

The P-type base regions comprise first P-type base regions 261 disposed in a rectangular array. Of course, the P-type base regions further comprise a second P-type base region 262 disposed in a center of a rectangle area enclosed by the first P-type base regions 261. The first P-type base regions 261 and the second P-type base region 262 are disposed on an upper portion of the N + blocking region 230.

For the super junction IGBT device, a P + collector region 100 is disposed below the N-type buffer region 210. A lower end of the P+ collector region 100 is connected to a collector metal (not shown in the drawings). Emitting regions are disposed on the N+ barrier region 230 and are disposed corresponding to the P-type base regions. At least one gate electrode 500 is disposed between the N+ barrier region 230 or the N+ barrier region 230 and a dielectric layer 600. The dielectric layer 600 is disposed on the N+ barrier region 230, and a gate metal (not shown in the drawings) and an emitter metal (not shown in the drawings) are disposed on the dielectric layer 600. The gate metal and the emitter metal are respectively connected to the gate electrodes 500 and the emitting regions through contact holes (not shown in the drawings). These are conventional structures of the super junction IGBT devices and are not described in detail herein.

The P-type columns comprise first P-type columns 251 and second P-type columns 252. The first P-type columns 251 are disposed between two adjacent first P-type base regions 261 in the same column (disposed in the Y-axis direction shown in FIG. 3). The second P-type columns 252 are disposed between two adjacent first P-type base regions 261 in the same row (disposed in the X-axis direction shown in FIG. 3). The first P-type columns 251 are connected to the first P-type base regions 261 by the controlled hole extraction structure. The controlled hole extraction structure is configured to define a hole extraction channel between the first P-type columns 251 and the first P-type base regions 261. When the super junction IGBT device is turned on, the hole extraction channel between the first P-type columns 251 and the first P-type base regions 261 is disconnected.

In the embodiment, super junction portions are not in a suspended state and are not directly connected to the P-type base regions, but are connected to the P-type base regions through the controlled hole extraction structure, so that when the super junction IGBT device is turned off, the first P-type columns 251 extract holes through the hole extraction channel to increase a turn-off speed. When the super junction IGBT device is turned on, the hole extraction channel is disconnected to increase a carrier injection concentration of the N- drift region 220 and reduce a Vcesat (i.e., saturation voltage drop) of the super junction IGBT device.

The controlled hole extraction structure comprises a shallow P well 280 and a first gate electrode 510. The shallow P well 280 connects the first P-type columns 251 to the first P-type base regions 261. The first gate electrode 510 is configured to control the shallow P well 280 to be in a depletion state. The shallow P well 280 is disposed on the upper portion of the N + blocking region 230. The first gate electrode 510 is disposed above the shallow P well 280. A first gate oxide layer 410 is disposed between the first gate electrode 510 and the N + blocking region 230. The first gate electrode 510 is disposed between the first gate oxide layer 410 and the dielectric layer 600. In the embodiment, the shallow P well 280 is disposed between the two adjacent first P-type base regions 261 in the same column, two ends of the shallow P well 280 are respectively connected to the two adjacent first P-type base regions 261 in the same column, and a middle portion of the shallow P well 280 is connected to upper ends of the first P-type columns 251. When the super junction IGBT device is turned on, a gate voltage of the gate electrode 500 depletes the shallow P well 280 disposed below the first gate electrode 510, thereby preventing the first P-type columns 251 from extracting the holes. When the super junction IGBT device is turned off, the shallow P well 280 restores, thereby opening the hole extraction channel, and the extraction of the holes by the first P-type columns 251 accelerates the turn-off speed of the super junction IGBT device.

The N + blocking region 230 defines trenches 300. Second gate electrodes 520 are respectively disposed in the trenches 300. The first gate electrode 510 extends to a position over the trenches 300 and are connected to the second gate electrodes 520. The super junction IGBT device further comprises second gate oxide layers 420, and each of the second gate oxide layers 420 is disposed between a groove wall of a corresponding one of the trenches 300 and a corresponding one of the second gate electrodes 520.

In the embodiment, the trenches 300 comprise two trenches 300. The two trenches 300 are disposed in parallel between two adjacent columns of the first P-type base regions 261, and each of the trenches 300 is disposed between a corresponding one of the second P-type columns 252 and a corresponding one of the first P-type base regions 261 (located on one side along the X-axis shown in FIG. 3)..

Of course, the two trenches 300 are respectively located between the second P-type base region 262 and a corresponding one of the first P-type columns 251 (located along the X-axis shown in FIG. 3). The super junction IGBT device further comprises emitting regions. The emitting regions comprise first emitting regions 271 respectively disposed above the first P-type base regions 261 and a second emitting region 272 disposed on the second P-type base region 262. Each of the first emitting regions 271 comprises a P + contact region 271b disposed away from a corresponding one of the trenches 300 and an N + emitting region 271a disposed between the P + contact region 271b and the corresponding one of the trenches 300.

A conduction process of the super junction IGBT device of this embodiment is as follows:

When the super junction IGBT device is turned on, the gate voltage Vge of the gate electrodes 500 is positive (+ 15V -+20V in a common circuit). Since the gate voltage is a positive voltage, the shallow P well 280 disposed below the first gate electrode 510 is depleted. At this time, a connection channel between the first P-type columns 251 and the first P-type base regions 261 is disconnected, and the hole extraction channel is closed. Thus, the super junction IGBT device of the present disclosure has advantages of the SJ-IGBT device of the prior art shown in FIG. 1. That is, when the super junction IGBT device is turned on, the P-type columns no longer extract holes, increasing the carrier injection concentration of the N- drift region 220, thereby reducing the Vcesat of the super junction IGBT device.

A turn-off process of the super junction IGBT device of the embodiment is as follows:

When the super junction IGBT device is turned off, the gate voltage Vge of the gate electrodes 500 is zero or is a negative voltage (negative voltage is commonly used, the Vge is - 15V to -20V). Since the gate voltage is the negative voltage, the shallow P well 280 that is previously depleted and disposed below the first gate electrode 510 restores from the depleted state. At this time, the connection channel (i.e., a P doped region) between the first P-type columns 251 and the first P-type base regions 261 is reconnected, and the hole extraction channel is restored. Thus, the super junction IGBT device of the present disclosure has advantages of the SJ-IGBT device of the prior art shown in FIG. 2. That is, the holes are extracted through the P-type columns, so that the holes are extracted faster, and a turn-off time of the super junction IGBT device is shortened.

In the embodiment, the P-type base regions are disposed above the N-type columns 240, so that the P-type columns are not directly connected to the P-type base regions. Then, the shallow P well 280 is defined to form the hole extraction channel connecting the first P-type columns 251 and the first P-type base regions 261, and the first gate electrode 510 is disposed above the shallow P well 280 to control on and off of the hole extraction channel. When the super junction IGBT device is turned on, the shallow P well 280 is depleted by the gate voltage of the first gate electrode 510, the extraction of the holes by the first P-type columns 251 is blocked, and the holes are inhibited from flowing to top ends of the first P-type columns 251, which increase the carrier injection concentration of the N- drift region 220, increase a current density, and reduce conduction loss. When the super junction IGBT device is turned off, the shallow P well 280 is restored, so that the hole extraction channel is opened, and the extraction of the holes by the first P-type columns 251 accelerates a turn-off speed of the super junction IGBT device. Therefore, the turn-off speed of the super junction IGBT device is accelerated, and the saturation voltage drop of the super junction IGBT device is not increased when the super junction IGBT device is turned on.

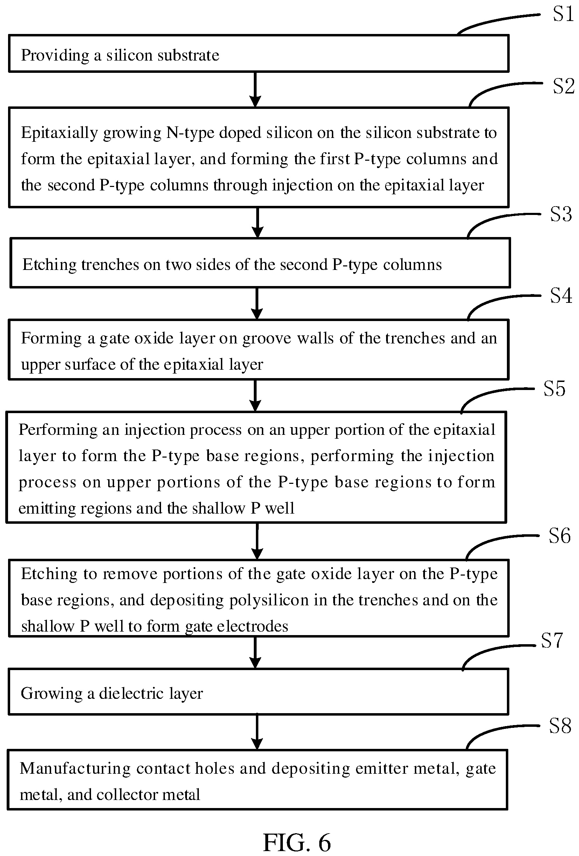

As shown in FIG. 6, the present disclosure provides a manufacturing method of the IGBT device based on the controlled hole extraction structure. In one optional embodiment, the manufacturing method comprises steps S1-S8.

The step S1 comprises providing a silicon substrate.

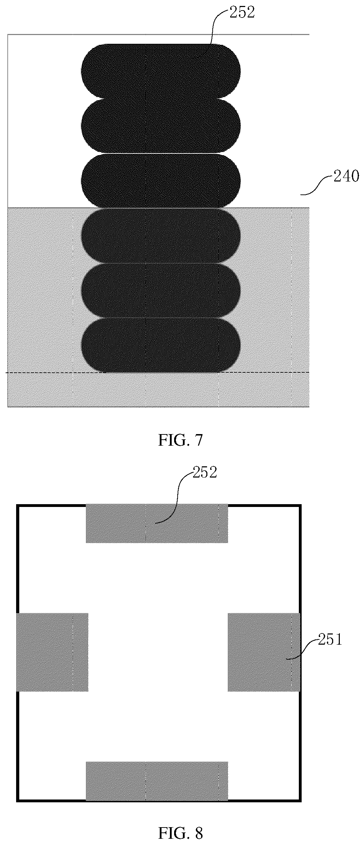

As shown in FIGS. 7 and 8, the step S2 comprises epitaxially growing N-type doped silicon on the silicon substrate to form the epitaxial layer 200, and forming the first P-type columns 251 and the second P-type columns 252 on the epitaxial layer 200 through injection. The epitaxial layer 200 comprises the N-type buffer region 210, the N- drift region 220, and the N + blocking region 230. The P-type columns are disposed in the N + blocking region 230. The first P-type columns 251 and the second P-type columns 252 extend downward into the N- drift region 220 from the N-type buffer region 210. The N- drift region 220 and the N + blocking region 230 without the P-type columns form the N-type columns 240, so that the P-type columns and the N-type columns 240 are periodically and alternately disposed.

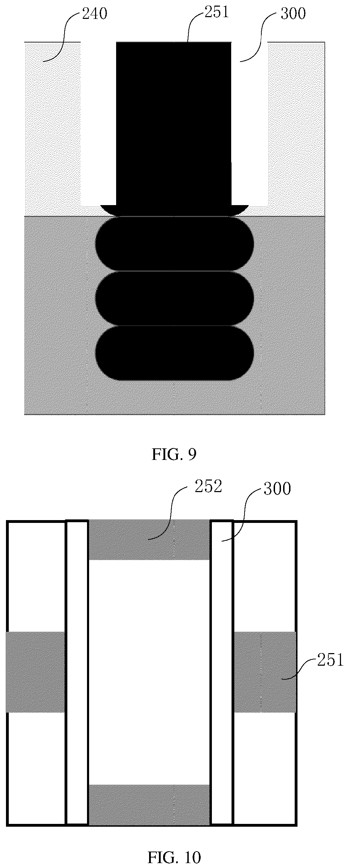

As shown in FIGS. 9 and 10, the step S3 comprises etching the trenches 300 on two sides of the second P-type columns 252.

As shown in FIG. 10, the step S4 comprises forming the gate oxide layer 400 on groove walls of the trenches 300 and an upper surface of the epitaxial layer 200. each of the first gate oxide layers 410 is formed on the groove wall of each of the trenches 300, and the second gate oxide layer 420 is formed on the upper surface of the epitaxial layer 200.

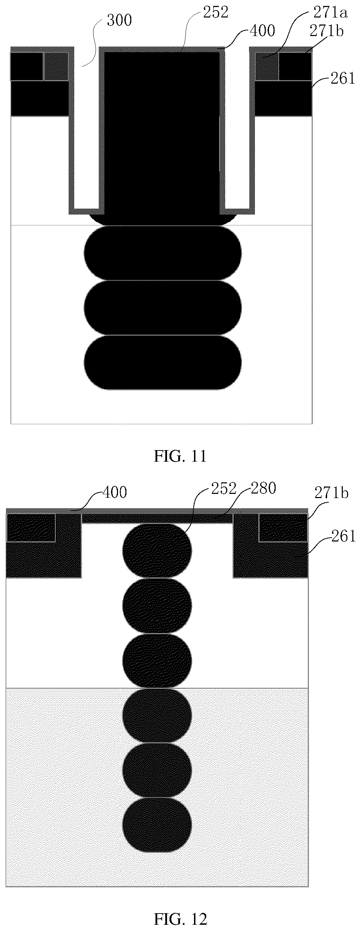

As shown in FIGS. 11 and 12, the step S5 comprises performing an injection process on an upper portion of the epitaxial layer 200 to form the P-type base regions, performing the injection process on upper portions of the P-type base regions to form the emitting regions and the shallow P well 280. The first emitting regions 271 are respectively disposed on the first P-type base regions 261, and the second emitting region 272 is disposed on the second P-type base region 262. Each of the first emitting regions 271 comprises the N+ emitting region 271a and the P+ contact region 271b.

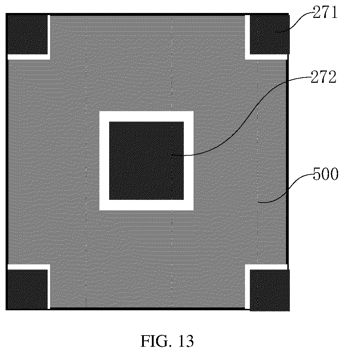

As shown in FIG. 13, the step S6 comprises depositing polysilicon, by a mask, in the trenches 300 and on the shallow P well 280 to form the gate electrodes 500. The polysilicon on the shallow P well 280 forms the first gate electrode 510, and the polysilicon in the trenches 300 forms the second gate electrodes 520.

As shown in FIGS. 3-5,the step S7comprises etching to remove portions of the gate oxide layer 400 on the P-type base regions, and growing the dielectric layer 600.

The step S8 comprises manufacturing contact holes and depositing metals. Specifically, the emitter metal, the gate metal, and the collector metal are deposited, and the step S8 is a conventional process in the prior art, which is not described in details herein.

The super junction IGBT device manufactured by the manufacturing method of the embodiment only uses the first P-type columns 251 to extract the holes to increase the turn-off speed of the super junction IGBT device when the super junction IGBT device is turned off, so as to reduce the turn-off loss of the super junction IGBT device. When the super junction IGBT device is turned on, the first P-type columns 251 do not extract the holes, thereby improving the turn-off speed when the super junction IGBT device is turned off without increasing the Vcesat of the super junction IGBT device when the super junction IGBT device is turned on.

## Claims

1. A super junction insulated gate bipolar transistor (IGBT) device based on a controlled hole extraction structure, comprising:
an epitaxial layer (200);
P-type columns and N-type columns (240) periodically disposed in the epitaxial layer (200); and
P-type base regions disposed above the N-type columns (240);
wherein the P-type base regions comprise first P-type base regions (261) disposed in a rectangular array, and the P-type columns comprise first P-type columns (251) and second P-type columns (252), the first P-type columns (251) are disposed between two adjacent first P-type base regions (261) in the same column, the second P-type columns (252) are disposed between two adjacent first P-type base regions (261) in the same row; the first P-type columns (251) are connected to the first P-type base regions (261) by the controlled hole extraction structure, the controlled hole extraction structure is configured to define a hole extraction channel between the first P-type columns (251) and the first P-type base regions (261), and when the super junction IGBT device is turned on, the hole extraction channel between the first P-type columns (251) and the first P-type base regions (261) is disconnected.

2. The super junction IGBT device according to claim 1, wherein the epitaxial layer (200) comprises an N-type buffer region (210), an N- drift region (220) disposed on the N-type buffer region (210), and an N + blocking region (230) disposed on the N- drift region (220); wherein the P-type base regions are disposed on an upper portion of the N + blocking region (230).

3. The super junction IGBT device according to claim 2, wherein the controlled hole extraction structure comprises a shallow P well (280) and a first gate electrode (510), the shallow P well (280) connects the first P-type columns (251) to the first P-type base regions (261), the first gate electrode (510) is configured to control the shallow P well (280) to be in a depletion state, the shallow P well (280) is disposed on the upper portion of the N + blocking region (230), the first gate electrode (510) is disposed above the shallow P well (280), and a first gate oxide layer (410) is disposed between the first gate electrode (510) and the N + blocking region (230).

4. The super junction IGBT device according to claim 3, wherein the shallow P well (280) is disposed between the two adjacent first P-type base regions (261) in the same column, two ends of the shallow P well (280) are respectively connected to the two adjacent first P-type base regions (261) in the same column, and a middle portion of the shallow P well (280) is connected to upper ends of the first P-type columns (251).

5. The super junction IGBT device according to claim 3, wherein the N + blocking region (230) defines trenches (300), second gate electrodes (520) are respectively disposed in the trenches (300), and the first gate electrode (510) extends to a position over the trenches (300) and are connected to the second gate electrodes (520);
wherein the super junction IGBT device further comprises second gate oxide layers (420), and each of the second gate oxide layers (420) is disposed between a groove wall of a corresponding one of the trenches (300) and a corresponding one of the second gate electrodes (520).

6. The super junction IGBT device according to claim 5, wherein the trenches (300) comprise two trenches (300); the two trenches (300) are disposed in parallel between two adjacent columns of the first P-type base regions (261), and each of the trenches (300) is disposed between a corresponding one of the second P-type columns (252) and a corresponding one of the first P-type base regions (261).

7. The super junction IGBT device according to claim 6, wherein the P-type base regions further comprise a second P-type base region (262) disposed in a center of a rectangle area enclosed by the first P-type base regions (261), the super junction IGBT device further comprises emitting regions, the emitting regions comprise first emitting regions (271) respectively disposed above the first P-type base regions (261) and a second emitting region (272) disposed on the second P-type base region (262).

8. The super junction IGBT device according to claim 7, wherein each of the first emitting regions (271) comprises a P + contact region (271b) disposed away from a corresponding one of the trenches (300) and an N + emitting region (271a) disposed between the P + contact region (271b) and the corresponding one of the trenches (300).

9. The super junction IGBT device according to claim 2, wherein the P-type columns are disposed in the N + blocking region (230), and the P-type columns extend downward into the N-drift region (220), the N- drift region (220) and the N + blocking region (230) around the P-type columns form the N-type columns (240), so that the P-type columns and the N-type columns (240) are periodically and alternately disposed.

10. The super junction IGBT device according to any one of claims 1-9, wherein a P + collector region (100) is disposed below the epitaxial layer (200), a dielectric layer (600) is disposed on the epitaxial layer (200), the first gate electrode (510) is disposed between the first gate oxide layer (410) and the dielectric layer (600), and the emitting regions are disposed on the P-type base regions.

11. A manufacturing method of the IGBT device based on the controlled hole extraction structure according to any one of claims 1-10, comprising:
providing a silicon substrate;
epitaxially growing N-type doped silicon on the silicon substrate to form the epitaxial layer (200), and forming the first P-type columns (251) and the second P-type columns (252) through injection on the epitaxial layer (200);
etching the trenches (300) on two sides of the second P-type columns (252);
forming a gate oxide layer (400) on groove walls of the trenches (300) and an upper surface of the epitaxial layer (200);
performing an injection process on an upper portion of the epitaxial layer (200) to form the P-type base regions, performing the injection process on upper portions of the P-type base regions to form the emitting regions and the shallow P well (280);
etching to remove portions of the gate oxide layer (400) on the P-type base regions, and depositing polysilicon in the trenches (300) and on the shallow P well (280) to form gate electrodes (500);
growing the dielectric layer (600);
manufacturing contact holes and depositing emitter metal, gate metal, and collector metal.
